Europäisches Patentamt

European Patent Office

Office européen des brevets

(19)

(11) Veröffentlichungsnummer : **0 049 828**
**B1**

(12) **EUROPÄISCHE PATENTSCHRIFT**

(45) Veröffentlichungstag der Patentschrift :
17.07.85

(21) Anmeldenummer : 81107839.3

(22) Anmeldetag : 02.10.81

(51) Int. Cl.⁴ : **G 01 N 3/08, B 32 B 35/00**

(54) **Vorrichtung zur Erfassung des Fliesspunktes von Harzlaminaten bei der Herstellung von Mehrschichtleiterplatten.**

(30) Priorität : 10.10.80 DE 3038268

(43) Veröffentlichungstag der Anmeldung :
21.04.82 Patentblatt 82/16

(45) Bekanntmachung des Hinweises auf die Patenterteilung : 17.07.85 Patentblatt 85/29

(84) Benannte Vertragsstaaten :
FR GB IT

(56) Entgegenhaltungen :
FR-A- 2 087 245
FR-A- 2 225 743
US-A- 3 276 131
US-A- 3 712 125
PLASTVERARBEITER 30, Nr. 9, 1979, SPEYER (DE) R. WIECHMANN et al.: "Zur Optimierung des Pressprozesses bei der Herstellung von kupferkaschierten Epoxidharz-Glaslaminaten", Seiten 519-523

(73) Patentinhaber : Robert Bürkle GmbH & Co.
Postfach 160
D-7290 Freudenstadt (DE)

(72) Erfinder : Bohn, Hans
Sonnenhalde 12
D-7294 Schopfloch (DE)
Erfinder : Stein, Wolfgang
Stumpengartenweg 6
D-7290 Freudenstadt (DE)
Erfinder : Bernsau, Peter
Bärenwiesenweg 7
D-7291 Wittlensweiler (DE)
Erfinder : Staubitzer, Fred
Eichendorffweg 5
D-7295 Dornstetten (DE)

(74) Vertreter : Frank, Gerhard, Dipl.-Phys. et al
Patentanwälte Dr. F. Mayer & G. Frank Westliche 24
D-7530 Pforzheim (DE)

## Beschreibung

Die Erfindung betrifft eine Vorrichtung zur Erfassung des Fließpunktes von Harzlaminaten bei der Herstellung von Mehrschichtleiterplatten mittels einer Preßplatten aufweisenden Heizpresse, mit einem Wegaufnehmer zur Bestimmung des Fließpunktes aus der Verschiebung einer der Preßplatten bezüglich der anderen.

Die Herstellung von Merschichtleiterplatten beruht darauf, daß zwischen den zu verbindenden Leiterplatten geeignete Kunststoffschichten, insbesondere Harzlaminate in Form von Zwischenplatten vorgesehen sind, die dann unter Wärmezufuhr und unter Anwendung eines Kontaktdruckes in den fließenden Zustand gebracht werden, worauf die Heizpresse dann den maximalen Preßdruck erzeugt, um eine Verbindung der Leiterplatten untereinander mittels der dazwischen liegenden Kunststoffschicht zu erreichen. Der bis zum Erreichen dieses Fließpunktes angewendete Kontaktdruck hat dabei die Aufgabe, die zugeführte Wärme möglichst gleichmäßig auf den Multilayer zu verteilen, wogegen der maximale Preßdruck zur Einleitung des Kondensationsvorganges des Kunststoffes benutzt wird. Für den Übergang vom Kontaktdruck zum maximalen Preßdruck ist daher die Erfassung des Fließpunktes des Harzlaminates von entscheidender Bedeutung, da nach Verstreichen einer vorgegebenen Zeitspanne nach Erreichen des Fließpunktes der maximale Preßdruck zur Verfügung gestellt werden muß.

Eine gattungsgemäße Vorrichtung, die aufgrund dieser Zusammenhänge den Fließpunkt erfassen soll, ist aus einem Artikel « Zur Optimierung des Preßprozesses bei der Herstellung von kupferkaschierten Epoxidharz-Glaslaminaten » in « Plastverarbeiter », 30. Jahrgang, 1979 Nr. 9, Seite 519 ff. bekannt.

In dieser Veröffentlichung wird für experimentelle Zwecke eine grafische, relativ langwierige Aufzeichnung des Fließverhaltens durchgeführt, die Auskünfte über die grundlegenden physikalischen Erscheinungen bei diesem Prozess vermitteln soll. Wie auch bisher schon üblich, erfordert diese Aufzeichnungsmethode eine individuelle Überwachung jedes Preßvorganges durch das Bedienungspersonal.

Ein besonderer Effekt wird in diesem Artikel ebenfalls angesprochen, nämlich die Verfälschung der aufgezeichneten Kurve durch thermische Dehnung der beteiligten Bauteile, insbesondere der Preßplatten. Dies wird dort durch eine Korrekturkurve gelöst, die mit der jeweiligen Aufzeichnung des Fließvorganges bei dem individuellen Preßvorgang verglichen werden muß.

Demgegenüber stellt sich die Erfindung zur Aufgabe, eine Vorrichtung zu schaffen, die eine schnelle und einfache Anwendung der Erfassung des Fließpunktes mit Hilfe der Verschiebung der Preßplatten zueinander auf die industrielle Massenfertigung erlaubt, wobei auch die Schwierigkeit der auftretenden Wärmedehnungen der beteiligten Bauteile berücksichtigt sein soll.

Dies erreicht die Erfindung durch die kennzeichnenden Merkmale des Patentanspruches 1.

Die erfindungsgemäße automatische Erfassung des Fließpunktes ermöglicht, einmal auf den spezifischen Multilayer und den Kunststoff eingestellt, eine Fertigung der Mehrschichtleiterplatten mit gleichbleibender Qualität, unbeeinflußt von den subjektiven Begleitumständen, die bei der manuellen Feststellung des Fließpunktes, sei es durch die üblicherweise bisher verwendete Teststäbchen, sei es durch die Aufzeichnung von Fließdruckkurven gemäß dem oben genannten Stand der Technik auftreten.

Ausgestaltungen der erfindungsgemäßen Vorrichtung sind den abhängigen Ansprüchen zu entnehmen.

Ein Ausführungsbeispiel der erfindungsgemäßen Vorrichtung wird nun anhand eines Blockschaltbildes näher erläutert.

Die Heizpresse 10 verfügt als wesentliche Bestandteile über mindestens 2 Preßplatten 11 und 12, zwischen denen ein Multilayer 15 eingespannt ist. Die untere Preßplatte (Preßtisch) 11 wird von hydraulischen Vorrichtungen 13 gegen die obere Preßplatte gedrückt. Die Steuerung des Preßdruckes übernimmt eine Drucksteuerung 60, die über Steuerleitungen 62 den Hydraulikvorrichtungen 13 entsprechende Steuerbefehle gibt und die über Meßleitungen 63 den zur Zeit herrschenden Preßdruck von geeigneten (nicht dargestellten) Meßeinrichtungen rückgemeldet bekommt.

Beim dargestellten Ausführungsbeispiel der Auswerteschaltung 80 wird nun die Verschiebung eines Bezugspunktes des Preßtisches 11 nach oben durch einen Wegaufnehmer 20 in elektrische Impulse umgesetzt, die auf einer Leitung 21 einer Zählvorrichtung 30 zugeführt werden. Der Starteingang dieser Zählvorrichtung 30 ist über eine Startleitung 61 mit der Drucksteuerung 60 verbunden ; sobald die Drucksteuerung von den Meßleitungen 63 über den Aufbau den Kontaktdruckes informiert worden ist, gibt sie über die Startleitung 61 ein Signal und startet die Zählvorrichtung 30. Mit wachsender Temperatur und Annäherung des Harzlaminates an den Fließpunkt bewegt sich die untere Preßplatte 11 etwas nach oben, und die Zählvorrichtungen 30 zählen die auf der Leitung 21 ankommenden Impulse.

Den Zählvorrichtungen 30 ist ein Richtungsdiskriminator 35 zugeordnet, der nur diejenigen Impulse der Leitung 21 zur Zählung freigibt, die einer Aufwärtsbewegung des Bezugspunktes des Preßtisches 11 entsprechen. Etwaige gegenläufige Impulse entsprechend einer thermisch bedingten Bewegung des Bezugspunktes des Preßtisches 11 nach unten werden dabei unterdrückt.

Die gezählten Impulse N gelangen auf eine Ausgangsleitung 31 zu einem Komparator 40, wo sie mit einem Schwellwert $N_F$ verglichen werden. Dieser Schwellwert $N_F$ ist dem Komparator von außen vorgegeben, er wird für den speziell verarbeiteten Multilayertyp empirisch bestimmt, die vorgegebene Impulsenzahl $N_F$ entspricht also einer bestimmten Strecke, die sich der Bezugspunkt des Preßtisches nach oben bewegt, wobei davon ausgegangen wird, daß eben diese Bewegung in diesem bestimmten Umfang nur dann möglich ist, wenn das Harzlaminat zwischen den Leiterplatten den Fließpunkt erreicht hat.

Ergibt der Vergleich im Komparator 40, daß der Zählerstand N den vorgegebenen Schwellwert $N_F$ erreicht hat, so gibt der Komparator auf seiner Ausgangsleitung 32 ein Startsignal an ein Zeitglied 50, das auf eine bestimmte Verzögerung $\Delta t$ eingestellt werden kann. Nach Ablauf dieser Zeitsparne $\Delta t$ gibt das Zeitglied auf seiner Ausgangsleitung 33 ein Signal an die Drucksteuerung 60 der Heizpresse 10, worauf diese über ihre Steuerleitung 62 die Hydraulikvorrichtungen 13 ansteuert und den herrschenden Druck vom bisher angelegten Kontaktdruck auf den maximalen Preßdruck erhöht.

Die gesamte aus den bauteilen 20, 30, 35, 40 und 50 bestehende Auswertschaltung 80 kann vorteilhaft in integrierter Technik aufgebaut sein und als Baueinheit hergestellt werden.

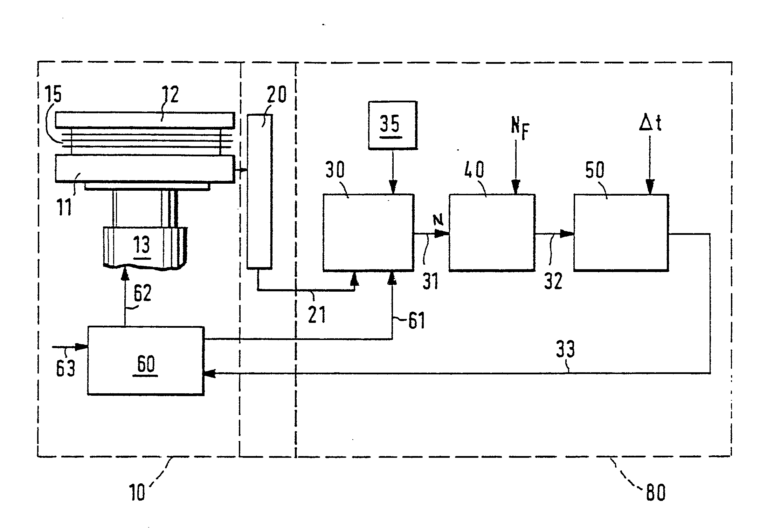

## Patentansprüche

1. Vorrichtung zur Erfassung des Fließpunktes von Harzlaminaten bei der Herstellung von Mehrschichtleiterplatten mittels einer Preßplatten (11, 12) aufweisenden Heizpresse (10), mit einem Wegaufnehmer (20) zur Bestimmung des Fließpunktes aus der Verschiebung einer (11) der Preßplatten (11, 12) bezüglich der anderen, dadurch gekennzeichnet, daß der Wegaufnehmer (20) zur Abgabe einer die Verschiebung repräsentierenden Folge von Impulsen ausgebildet ist, daß eine dem Wegaufnehmer (20) nachgeschaltete Auswerteschaltung (80) eine Zählvorrichtung (30) zum Aufaddieren der Impulse (N) und einen Komparator (40) zum Vergleich der aufaddierten Impulse (N) mit einem vorgegebenen Schwellwert ($N_F$) umfaßt, daß die Auswerteschaltung so ausgebildet ist, daß nur diejenigen Impulse (N) aufaddiert werden, die die Verschiebung der verschiebbaren Preßplatte (11) in der Schließrichtung repräsentieren und daß beim Erreichen des Schwellwertes ($N_F$) der der Fließpunkt signalisiert wird.

2. Vorrichtung nach Anspruch 1, dadurch gekennzeichnet, daß dem Komparator (40) ein Zeitglied (50) nachgeschaltet ist, das das vom Komparator (40) abgegebene Signal mit einer einstellbaren Verzögerung ($\Delta t$) weiterleitet.

3. Vorrichtung nach Anspruch 1 oder 2, dadurch gekennzeichnet, daß das vom Komparator (40) bzw. vom Zeitglied (50) abgegebene Signal zur Steuerung des Aufbaues eines maximalen Preßdruckes dient.

## Claims

1. Device for the recognition of the pour points of plastics laminates during the production of multi-layer printed circuit boards by means of a heating press (10) provided with pressure plates (11, 12), comprising a displacement transducer (20) for determing the pour point from the displacement of one (11) of the pressure plates (11, 12) relative to the other, characterised in that the displacement transducer (20) is adapted to release a train of pulses representing the displacement, in that an evaluation circuit (80), which is connected to the output end of the displacement transducer (20), includes a counting device (30) for adding-up the pulses (N) and a comparator (40) for comparing the added-up pulses (N) with a predetermined threshold value ($N_F$), in that the evaluation circuit is so adapted that only those pulses (N) are added-up which represent the displacement of the displaceable pressure plate (11) in the closing direction, and in that the pour point is signalised when the threshold value ($N_F$) has been reached.

2. Device according to claim 1, characterised in that a timing member (50) is connected to the output end of the comparator (40) and passes-on the signal, which has been released by the comparator (40), with an adjustable delay ($\Delta t$).

3. Device according to claim 1 or 2, characterised in that the signal released by the comparator (40) or by the timing member (50), respectively, serves to control the build-up of a maximum pressure.

## Revendications

1. Dispositif qui, destiné à déterminer le point d'écoulement de stratifiés à base de résine lors de la fabrication de plaquettes multicouches à circuits imprimés au moyen d'une presse chauffante (10) comportant des plateaux de compression (11, 12), comprend un capteur de déplacement (20) pour déterminer le point d'écoulement à partir du déplacement de l'un (11) des plateaux de compression (11, 12) par rapport à l'autre, caractérisé en ce que le capteur de déplacement (20) est réalisé pour délivrer une suite d'impulsions représentative du déplacement, en ce qu'un circuit de traitement (80) monté en aval du capteur de déplacement (20) comprend un dispositif de comptage (30) pour compter les impulsions (N) et un comparateur (40) pour comparer les impulsions comptées (N) avec une valeur de seuil préétablie ($N_F$), en ce que le circuit de traitement est réalisé de telle manière que soient comptées exclusivement les impulsions (N) qui représentent le déplacement effectué par le plateau de compression coulissant (11) dans le sens de fermeture et en ce qu'au moment où la valeur de seuil ($N_F$) est atteinte le point d'écoulement est signalé.

2. Dispositif selon la revendication 1, caractérisé en ce qu'en aval du comparateur (40) est monté un relais temporisateur (50) par lequel le signal délivré par le comparateur (40) est transmis avec un retard réglable ($\Delta t$).

3. Dispositif selon la revendication 1 ou 2, caractérisé en ce que le signal délivré par le comparateur (40), c'est-à-dire par le relais temporisateur (50), sert à commander l'établissement d'une pression de serrage maximale.